(19) Europäisches Patentamt
European Patent Office
Office européen des brevets

(11) Numéro de publication: **0 181 246**
**A1**

(12) **DEMANDE DE BREVET EUROPEEN**

(21) Numéro de dépôt: 85401964.3

(22) Date de dépôt: 08.10.85

(51) Int. Cl.[4]: **H 01 L 29/40**
H 01 L 29/64

(30) Priorité: 09.10.84 FR 8415491

(43) Date de publication de la demande: 14.05.86 Bulletin 86/20

(84) Etats contractants désignés: DE GB NL

(71) Demandeur: THOMSON-CSF
173, Boulevard Haussmann
F-75379 Paris Cedex 08(FR)

(72) Inventeur: Marengo, Michel
THOMSON-CSF SCPI 173, bld Haussmann
F-75379 Paris Cedex 08(FR)

(72) Inventeur: Kohn, Erhard
THOMSON-CSF SCPI 173, bld Haussmann
F-75379 Paris Cedex 08(FR)

(72) Inventeur: Cathelin, Michel
THOMSON-CSF SCPI 173, bld Haussmann
F-75379 Paris Cedex 08(FR)

(74) Mandataire: Taboureau, James et al,
THOMSON-CSF SCPI 19, avenue de Messine
F-75008 Paris(FR)

(54) **Dispositif semiconducteur comportant un contact Schottky, et procédé de réalisation d'un tel dispositif.**

(57) L'invention concerne un contact Schottky dont les caractéristiques de tenue en température de recuit sont améliorées.

Un contact Schottky est formé entre un ou plusieurs métaux, de façon plus générale un système métallique réfractaire (1), et une couche d'un matériau semiconducteur (2). Ce type connu de contact Schottky se dégrade aux températures supérieures à 750°C, au cours des opérations de réalisation d'un dispositif semiconducteur tel qu'un transistor. Selon l'invention, une couche interfaciale (8) formant barrière de diffusion est introduite entre la métallisation (1) et la couche semiconductrice (2). Cette couche interfaciale est constituée par un composé chimique avec une molécule additionnelle, dans lequel la liaison métal/molécule additionnelle est supérieure à la liaison métal/matériau semiconducteur. La couche interfaciale est préférentiellement un nitrure métallique, et a une épaisseur de l'ordre de quelquels centaines d'angstrõms.

Application aux MESFETS sur matériaux III-V et aux varactors.

FIG_3

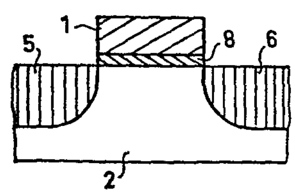


EP 0 181 246 A1

# DISPOSITIF SEMICONDUCTEUR COMPORTANT UN CONTACT SCHOTTKY, ET PROCEDE DE REALISATION D'UN TEL DISPOSITIF

La présente invention concerne un contact métallique de type Schottky, réalisé sur des matériaux semiconducteurs rapides du groupe III-V, tel que GaAs par exemple. Ce conctat métallique est amélioré par la présence d'une couche interfaciale, située à la jonction métal Schottky/matériau semiconducteur : elle permet au contact Schottky de subir des températures de recuit élevées sans détérioration de l'interface métal/semiconducteur, et par conséquent sans altération de la hauteur de barrière.

Les contacts Schottky sont très utilisés dans la réalisation de dipôles et quadripôles semiconducteurs, tels que les diodes ou les transistors à effet de champ. Dans ces derniers, il est particulièrement commode de réaliser la métallisation de grille au moyen d'un métal ou alliage métallique formant une jonction dite de Schottky avec le matériau semiconducteur : cette métallisation, utilisée comme masque, permet d'auto-aligner sur les bords les caissons de reprise une couche $n^+$ de conctat avec les métallisations de source et drain du transistor. L'inconvénient des métallisations Schottky connues est que, au cours du recuit à haute température, de l'ordre de 800 à 900°C qui suit la réalisation de ces caissons, pour l'activation de l'implantation d'ions ou de diffusion, certains des atomes constituant la métallisation Schottky diffusent dans la couche de matériau semiconducteur. Ces diffusions modifient l'interface métal/semiconducteur, ce qui change la hauteur de barrière Schottky du contact, ou détruit le contact.

Selon l'invention, une fine couche interfaciale, constituant une barrière de diffusion pour les atomes métalliques, est interposée entre la métallisation Schottky et la couche de matériau de semiconducteur : elle fait partie de la métallisation et n'est pas diffusée

dans le matériau semiconducteur. Cette couche interfaciale est composée par un nitrure du métal ou de l'alliage métallique formant le contact Schottky, ou, de façon plus générale, par un composé chimique formé avec une molécule additionnelle non métallique, tel que la liaison entre le métal et cette molécule soit supérieure à la liaison entre le métal et le matériau semiconducteur.

Si parmi les nombreux métaux réfractaires qui forment des contacts Schottky, on a choisi de déposer, par exemple, l'alliage WSi, la couche interfaciale est composée du nitrure $W_x$ $Si_y$ $N_z$, les indices x, y, z étant choisis en fonction des caractéristiques recherchées pour le conctat Schottky : valeur de la hauteur de barrière, valeur de son facteur de qualité, métallisation sous forme eutectique ou non, adaptation des coefficients mécaniques des réseaux cristallins métal/matériau semiconducteur ... etc.

De façon plus précise l'invention concerne un dispositif semiconducteur comportant un contact dit de Schottky, formé entre une métallisation constituée par un système métallique réfractaire et une couche de matériau semiconducteur, ce dispositif étant caractérisé en ce que la métallisation comporte, située à la jonction avec le matériau semiconducteur, une couche interfaciale formant barrière de diffusion, et formée par un composé chimique stable entre au moins un métal du système métallique et une molécule additionnelle, le composé chimique étant tel que la liaison entre le système métallique et la molécule additionnelle est supérieure à la liaison entre le système métallique et le matériau semiconducteur.

L'invention sera mieux comprise par la description d'un exemple de réalisation d'un contact Schottky, cette description s'appuie sur les figures jointes en annexe qui représentent :

- figure 1 : coupe partielle de la région de grille d'un transistor à effet de champ selon l'art connu,
- figure 2 : courbe montrant la dégradation du facteur de qualité d'un contact Schottky, en fonction de la température,
- figure 3 : coupe d'un contact Schottky, selon l'invention,
- figure 4 : caractéristique de transfert $I_D$ $(V_G)$ d'un MESFET

selon l'invention,

- Figure 5 : caractéristiques de saturation d'un transistor à effet de champ à grille Schottky autoalignée selon l'invention.

Les contacts Schottky sont couramment réalisés sur des matériaux tels que le silicium, ou sur ceux du groupe III-V, tels que GaAs, Al Ga As, InP...etc, et ils constituent au moins une électrode soit dans des diodes soit dans des transistors. De façon à simplifier les explications, l'invention sera exposée en s'appuyant sur le cas de la métallisation de grille Schottky dans un transistor à effet de champ dont le matériau semiconducteur est GaAs . Ceci ne constitue nullement une limitation à la portée de l'invention, qui est applicable de façon générale à tous les dispositifs semiconducteurs comportant au moins un contact Schottky.

La figure 1 représente la coupe partielle de la région de grille d'un transistor à effet de champ selon l'art connu. Ce transistor est de type MESFET, c'est-à-dire que c'est un transistor métal/semiconducteur : les transistors de type Mos ou Mis ne sont pas concernés par l'invention puisqu'ils comportent une couche d'oxyde ou une couche isolante entre la métallisation de grille et le matériau semiconducteur. Dans le cas d'un MESFET, la métallisation Schottky de grille 1 est déposée directement sur le matériau 2 semiconducteur : l'ensemble de la pastille de matériau semiconducteur 2 est simplifié, et les différentes couches semiconductrices, de types variés et formant les jonctions qui constituent le corps d'un transistor, ne sont pas représentées de façon à simplifier la figure. Lorsqu'il s'agit d'un transistor, il est nécessaire de compléter sa structure par des métallisations de source et de drain 3 et 4, qui sont déposées en surface de la pastille du transistor, de part et d'autre de la métallisation de grille 1. Cependant afin d'améliorer le contact entre les métallisations ohmiques 3 et 4, et le canal, transportant le courant entre ces mêmes métallisations, il est préférable de réaliser deux caissons 5 et 6 bons conducteurs, sur lesquels sont déposées les métallisations ohmiques 3 et 4. Ces caissons 5 et 6 sont réalisés par des procédés connus de l'homme de

l'art, tels que l'implantation ionique ou la diffusion d'impuretés, en utilisant la métallisation de contact Schottky 1 comme masque pour autoaligner les bords des caissons 5 et 6 sur les bords de la métallisation de grille 1. Après que les caissons ont été implantés, il est nécessaire de porter l'ensemble du dispositif à haute température pour activer l'implantation dans les caissons. C'est au cours de cette opération de recuit que certains atomes du métal ou des métaux constituant la métallisation Schottky diffusent dans le matériau semiconducteur, formant ainsi une zone 7, irrégulière, diffusée dans la pastille semiconductrice. Cette zone de diffusion modifie les caractéristiques d'interface, et par conséquent modifie la nature du contact Schottky.

Les contacts Schottky sont classiquement réalisés au moyen de couches métalliques ou de systèmes métalliques réfractaires tels que TiW, SiTiW, SiW, SITa, WAl ....etc. La technique d'autoalignement d'une grille en métal réfractaire ou en un système métallique réfractaire est une technique efficace pour réduire la résistance parallèle dans un transistor de type MESFET sur GaAs. Mais cette technique nécessite le recuit des zones implantées 5 et 6, et la clé de cette technique est le choix d'une grille métallique qui maintienne un bon contact Schottky avec GaAs même après un recuit à 800 ou 900°C.

Dans le cas d'une métallisation Schottky constituée par Si TiW, le tungstène est nécessaire car c'est lui qui assure un bon contact Schottky, le titane permet une meilleure adhérence de la couche, car il adapte entre eux les coefficients d'élasticité des couches métalliques et semiconductrices, le silicium freine partiellement la diffusion du titane dans GaAs. Un tel alliage n'est stable au cours de l'opération de recuit précitée que jusqu'à des températures de l'ordre de 750°C. Il est cependant nécessaire pour bien activer les caissons implantés 5 et 6, de pouvoir monter la température de recuit jusque au moins 800-900°C, sinon apparait la zone de diffusion 7, qui détériore les caractéristiques des barrières Schottky.

La hauteur de barrière d'un système métal/semiconducteur

est, pour GaAs, déterminée par l'état de surface et est de l'ordre de 0,8eV. L'état de surface, c'est-à-dire l'état de l'interface entre le métal et le semiconducteur, comporte normalement une couche interfaciale dont l'épaisseur est de l'ordre de la distance atomique : cette couche interfaciale correspond à l'interpénétration des atomes de métal dans le réseau cristallin du matériau semiconducteur. Or, s'il y a diffusion d'atome de métal au cours de l'opération de recuit, cette couche interfaciale n'est plus, et de beaucoup, d'épaisseur de l'ordre de la distance atomique, mais elle est beaucoup plus importante, et n'est plus à ce moment transparente aux électrons. Par conséquent les diagrammes d'énergie de bande entre un métal et un semiconducteur sont détériorés, la hauteur de barrière Schottky est modifiée, et le facteur de qualité détérioré.

Pour caractériser un contact Schottky, on peut utiliser la formule connue :

$$J = A^{**}T^2 \exp \frac{-\phi_b}{KT} \left[ \exp \frac{qV}{nKT} \right]$$

Dans :

$J$ = densité de courant
$A^{**}$ = constante de Richardson
$T$ = température
$q$ = charge de l'électron
$\phi_b$ = hauteur de barrière Schottky
$n$ = facteur de qualité du contact.

La hauteur de barrière $\phi_b$ et la constante de Richardson sont une caractéristique essentielle des contacts Schottky, qui sont détériorés par la zone de diffusion 7 d'atomes métalliques dans le semiconducteur. L'invention vise à augmenter la hauteur de barrière d'une métallisation Schottky, en créant, entre la métallisation 1 et le corps en matériau semiconducteur 2, une barrière qui s'oppose à la diffusion des atomes métalliques, vers la couche active qui est, dans le corps en matériau semiconducteur, au contact de la grille Schottky.

C'est ce que représente la figure 2 dans laquelle, entre la métallisation Schottky 1 et le corps semiconducteur 2, est interposée une mince couche interfaciale 8 encore conductrice de nitrure des métaux qui assurent le contact Schottky. Ainsi, si le contact Schottky est constitué par le système SiTiW qui constitue la métallisation 1, la barrière 8 est constituée par un nitrure N SiTiW. La liaison entre un atome d'azote et des atomes métalliques tels que W ou Si est supérieure à la liaison entre le matériau semiconducteur tel que GaAs et des atomes tels que W ou Si. Par conséquent, la présence d'atomes d'azote qui forment avec le ou les métaux du contact Schottky le nitrure, constitue une barrière de diffusion des atomes métalliques vers le matériau semiconducteur. Cette couche interfaciale 8 est constituée par une épaisseur nitrurée d'épaisseur de l'ordre de quelques centaines d'angströms ce qui n'est pas du tout comparable avec la couche interfaciale d'épaisseur d'ordre de la distance atomique dont il a été fait mention précédemment. En outre, la couche interfaciale 8 n'est pas diffusée dans le corps du matériau semiconducteur, mais fait partie de la métallisation Schottky : elle ne pénètre pas dans la couche active.

Alors que la hauteur de barrière $\phi_b$ est une caractéristique d'un contact Schottky, le facteur de qualité "n" permet de juger ou de comparer entre eux des contacts Schottky.

La figure 3 donne la variation du facteur de qualité "n" en fonction des températures de recuits pour différentes technologies de réalisation de contact Schottky par matériaux réfractaires. En abscisse sont portées les températures de recuit, 750° étant la température maximum admissible avec les alliages Schottky de métaux tels que Ti, W, Si, 850° étant la température atteinte par l'alliage nitruré selon l'invention, sans qu'il y ait de détérioration significative du facteur de qualité "n". Ainsi, alors qu'un bon facteur de qualité "n" doit être le plus voisin possible de l'unité, on trouve dans la littérature des courbes telles que 9 et 10 pour laquelle n = 1,14 entre 700° et 850°, ou n = 1,17 à 800°, pour une métallisation Schottky SiTiW. Avec une métallisation WAl, n = 1,1 entre 700° et

900°C. Ces valeurs connues correspondent aux courbes 9 et 10 de la figure 3.

Au contraire avec le contact Schottky selon l'invention, la courbe représentative de "n" en fonction de la température est représentée par la courbe 11, et donnée de façon plus précise dans le tableau ci-dessous :

| T | 600 | 750 | 800 | 850 |
|---|---|---|---|---|
| n | 1,05 | 1,05 | 1,06 | 1,07 |
| $\phi_b$ | 0,78V | 0,82V | 0,84V | 0,85V |

Ces valeurs montrent que le facteur de qualité "n" est pratiquement indépendant de la température de recuit au moins jusque 850°C.

En outre le tableau ci-dessus comporte la mesure des hauteurs de barrière $\phi_b$ à différentes températures et il est remarquable que la hauteur de barrière s'accroit avec la température de recuit, lorsque le contact Schottky est nitruré selon l'invention. Alors que dans la littérature la hauteur de barrière est classiquement comprise entre 0,7 et 0,75 V pour un système métal/GaAs, la hauteur de barrière est augmentée d'environ 0,8 électron-volts et passe à 0,86 électron-volts dans un système métal nitruré/GaAs selon l'invention.

Enfin, la tension de claquage d'un dispositif semiconducteur comportant un contact Schottky nitruré selon l'invention est améliorée : par exemple pour un recuit à 850°C, la tension de claquage du système SiTiW est 6 Volts, tandis que la tension de claquage d'un contact nitruré selon l'invention, Si TiWN est égale à 12 Volts, sur une couche de GaAs de l'ordre de $10^{17}$ $cm^{-3}$.

Un avantage du contact Schottky nitruré selon l'invention consiste en le fait qu'une couche SiTiWN est plus résistante qu'une couche du système SiTiW non nitruré. Par conséquent la couche

interfaciale nitrurée 8 introduit un limiteur de courant entre le contact Schottky 1 et le corps semiconducteur 2 pour le mode de fonctionnement en enrichissement (diode Schottky en direct). Ceci est représenté en figure 4 qui donne la caractéristique I (V) d'un transistor, muni d'une grille Schottky selon l'invention. Si l'on mesure le courant de drain $I_D$ en fonction de la tension positive de grille $V_G$, la courbe a l'aspect de la fraction de courbe 12, avec augmentation du courant en fonction de la tension. Dans le cas d'un transistor normal, c'est-à-dire ne comportant pas une grille nitrurée, cette courbe se limiterait à un point 13 au delà duquel on atteint la tension de claquage de dispositif de semiconducteur. Mais dans le cas d'un transistor muni d'une grille nitrurée selon l'invention, la résistance série constituée par la couche interfaciale 8 introduit un limiteur de courant, qui fait que la courbe 12 se prolonge par une courbe 14 qui présente une saturation : ce limiteur de courant protège le transistor. Cet aspect du contact Schottky selon l'invention est particulièrement intéressant car il permet d'utiliser des transistors de type MESFET en microondes, dans des systèmes limiteurs ou oscillateurs par exemple, qui admettent le passage de courants relativement importants.

Le fait qu'un contact Schottky nitruré selon l'invention présente une couche interfaciale 8 résistante n'est pas intéressant pour une diode mélangeuse, qui doit être peu résistante pour laisser passer le courant ; par contre un contact Schottky nitruré résistant est intéressant pour la réalisation d'un varactor qui travaille en inverse : la couche résistante évite les chutes de courant et protège la diode à proximité du potentiel de claquage.

La figure 5 représente les caractéristiques de saturation d'un transistor à effet de champ à grille submicronique Schottky autoalignée selon l'invention, pour des tensions de polarisation de grille $V_G$ compris entre 0 et 0,8 Volts.

La réalisation d'un contact nitruré selon l'invention se fait selon une technologie bien connue de métallisation par pulvérisation sous vide dans des appareils qui ne nécessitent aucune modification.

A titre d'exemple, du silicium est pulvérisé en même temps qu'un alliage ou un eutectique de différents métaux, tel que WTi dans les proportions de 15% en atomes pour le silicium dans un eutectique de 90 + 10% en atomes pour WTi. Au début de l'opération de pulvérisation sous vide, un plasma comportant de l'azote dans l'argon, est introduit dans l'appareil de pulvérisation. La durée de l'opération varie avec les caractéristiques de l'appareil de pulvérisation mais il est nécessaire d'obtenir une couche nitrurée de l'ordre de quelques centaines d'angströms d'épaisseur, le plasma d'azote dans l'argon étant supprimé lorsque cette épaisseur de couche est atteinte, puis le dépôt de la métallisation 1 non nitrurée continue selon les régles de l'art. La résistivité de la couche nitrurée peut être contrôlée par le pourcentage d'azote dans l'argon.

## REVENDICATIONS

1. Dispositif semiconducteur comportant un contact dit de Schottky, formé entre une métallisation (1) constituée par un système métallique réfractaire et une couche (2) de matériau semiconducteur, ce dispositif étant caractérisé en ce que la métallisation (1) comporte, située à la jonction avec le matériau semiconducteur (2), une couche interfaciale (8) formant barrière de diffusion, formée par un composé chimique stable entre au moins un métal du système métallique et une molécule additionnelle, le composé chimique étant tel que la liaison entre le système métallique et la molécule additionnelle est supérieure à la liaison entre le système métallique et le matériau semiconducteur (2).

2. Dispositif semiconducteur comportant un contact Schottky selon la revendication 1, caractérisé en ce que la molécule additionnelle est l'azote, et le composé chimique formant la couche interfaciale (8) est une nitrure de métal réfractaire.

3. Dispositif semiconducteur comportant un contact Schottky selon la revendication 2, caractérisé en ce que la couche interfaciale (8) a une épaisseur supérieure à une distance atomique, et est de l'ordre de quelques centaines d'angströms.

4. Dispositif semiconducteur comportant un contact Schottky selon la revendication 2, caractérisé en ce que, le système métallique constituant la métallisation Schottky (1) étant composé d'au moins un parmi les métaux W, Ti, Al, Ta, Si, le composé chimique formé est une nitrure de type WSiN, TiWSiN, WAlN, dont les proportions de chaque constituant sont choisies en fonction des caractéristiques requises pour le métal Schottky, et du matériau semiconducteur (2).

5. Dispositif semiconducteur comportant un contact Schottky selon la revendication 1, caractérisé en ce que le matériau semiconducteur est choisi parmi Si ou les composés du groupe III-V tels que GaAs, AlGaAs, InP ...

6. Dispositif semiconducteur comportant un contact Schottky

selon la revendication 2, caractérisé en ce que la résistivité de la couche interfaciale (8) nitrurée est supérieure à la résistivité du système métallique constituant la métallisation (1) d'un contact Schottky.

7. Dispositif semiconducteur comportant un contact Schottky selon la revendication 1, caractérisé en ce qu'il constitue la métallisation de grille (1) d'un transistor à effet de champ de type MESFET, dans lequel la couche interfaciale (8) introduit un limiteur de courant qui protège le transistor aux tensions de grille $V_G$ élevées.

8. Dispositif semiconducteur comportant un contact Schottky selon la revendication 1, caractérisé en ce qu'il constitue la métallisation de cathode d'une diode à capacité variable (varactor).

9. Procédé de réalisation d'un dispositif semiconducteur comportant un contact Schottky selon la revendication 2, caractérisé en ce que le dépôt du système métallique, en vue de former la métallisation Schottky (1), se fait en appareil de pulvérisation sous vide et comporte une étape préliminaire en présence d'un plasma comprenant de l'azote comme gaz réactif.

0181246

1/1

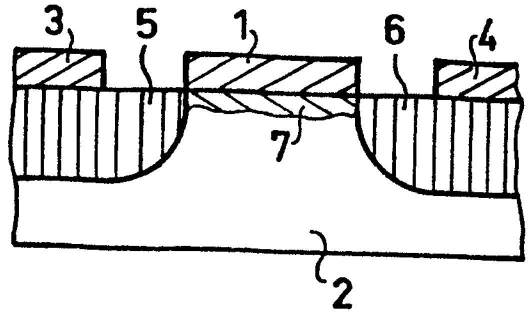


FIG_1

FIG_2

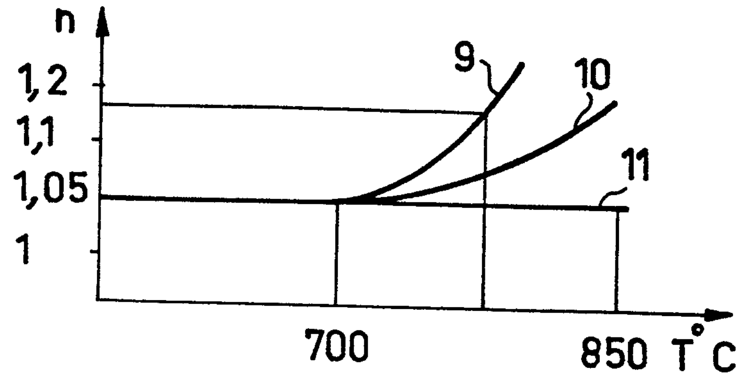


FIG_3

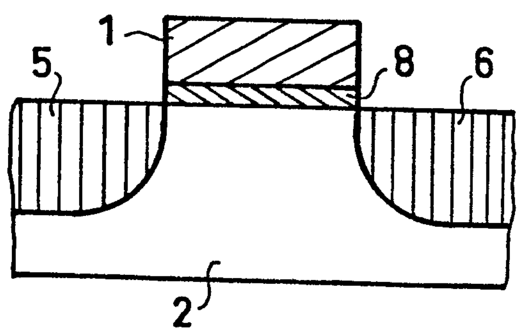


FIG_4

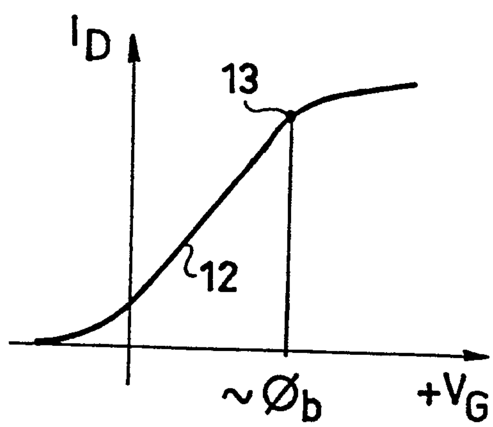


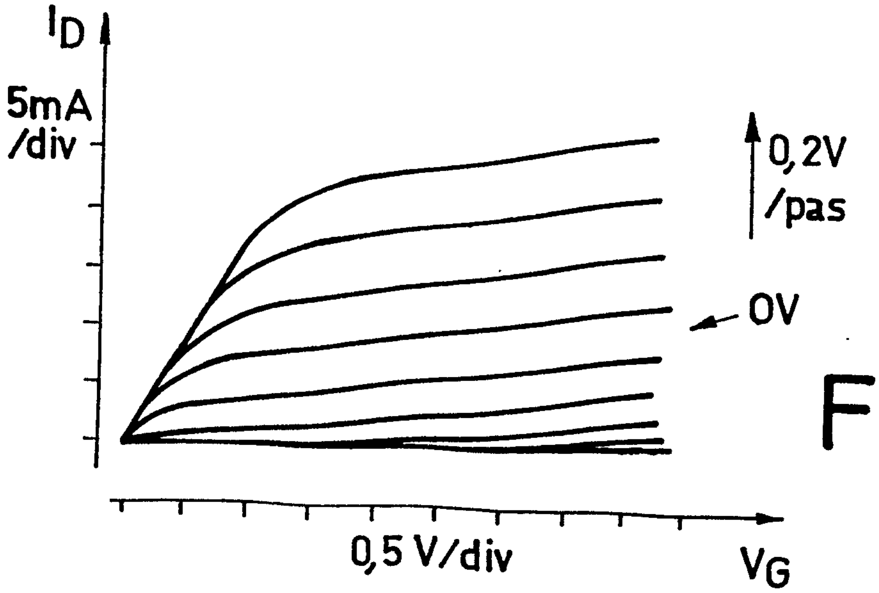


FIG_5

Office européen des brevets

**RAPPORT DE RECHERCHE EUROPEENNE**

**0181246**
Numero de la demande

EP 85 40 1964

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| X | IBM TECHNICAL DISCLOSURE BULLETIN, vol. 20, no. 9, février 1978, pages 3475,3476, New York, US; J.J. GNIEWEK et al.: "High ideality Schottky barrier diodes"<br>* En entier *<br>--- | 1 | H 01 L 29/40<br>H 01 L 29/64 |
| A | APPLIED PHYSICS LETTERS, vol. 43, no. 1, juillet 1983, pages 87-89, American Institute of Physics, New York, US; J.R. WALDROP: "Titanium nitride Schottky-barrier contacts to GaAs"<br>* Résumé *<br>--- | 1-5 | |
| A | EP-A-0 055 932 (FUJITSU LTD.)<br>* Résumé; revendications 3,4 *<br>--- | 1,4,5,<br>7,9 | **DOMAINES TECHNIQUES RECHERCHES (Int. Cl.4)** |
| A | IEEE TRANSACTIONS ON ELECTRON DEVICES, vol. ED-29, no. 10, octobre 1982, New York, US; N. YOKOYAMA et al.: "TiW silicide gate self-alignment technology for ultra-high-speed GaAs MESFET LSI/VLSI's"<br>* Paragraphe 3 *<br>----- | 1,4,5,<br>7,9 | H 01 L |

Le présent rapport de recherche a été établi pour toutes les revendications

| Lieu de la recherche | Date d achèvement de la recherche | Examinateur |
|---|---|---|
| LA HAYE | 27-01-1986 | PELSERS L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant